(19) Europäisches Patentamt / European Patent Office / Office européen des brevets

(11) **EP 3 715 861 A1**

(12) **EUROPEAN PATENT APPLICATION**

(43) Date of publication:
**30.09.2020 Bulletin 2020/40**

(51) Int Cl.:
**G01P 13/00** (2006.01)   **B65G 43/08** (2006.01)
**G01D 5/14** (2006.01)

(21) Application number: **20165274.0**

(22) Date of filing: **24.03.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.03.2019 JP 2019059119**

(71) Applicant: **Ishida Co., Ltd.
Kyoto-shi, Kyoto 606-8392 (JP)**

(72) Inventors:
• **YAMASHITA, Bunpei**
**Ritto-shi, Shiga 520-3026 (JP)**
• **KUNISAKI, Yoshito**
**Ritto-shi, Shiga 520-3026 (JP)**
• **NAKATANI, Makoto**
**Ritto-shi, Shiga 520-3026 (JP)**

(74) Representative: **Global IP Europe
Patentanwaltskanzlei
Pfarrstraße 14
80538 München (DE)**

(54) **ARTICLE MOVEMENT DETECTION SYSTEM AND METHOD FOR DETECTING ARTICLE MOVEMENT**

(57)    An article movement detection system includes a first sensor and a second sensor disposed facing a movement path of an article and is capable of individually detecting that the article has moved, and a detection unit detecting movement of the article on the basis of a first output being output from the first sensor and a second output being output from the second sensor. The first sensor and the second sensor are disposed at different positions in a moving direction of the article, and a first detection signal and a second detection signal are output with a time lag therebetween. The detection unit detects movement of the article on the basis of the first detection signal and the second detection signal.

*Fig.2*

**Description**

TECHNICAL FIELD

The present disclosure relates to an article movement detection system and a method for detecting article movement.

BACKGROUND

A detection system and a detection method for detecting a magnetic substance present inside a product are known. For example, in the method and the system described in Patent Document 1, a magnetic substance such as a broken needle which has been erroneously incorporated into a non-magnetic product is detected. In this method, a magnetic sensor serving as detection means is provided at a predetermined position between a pair of magnetic shielding materials. While a non-magnetic product into which a broken needle (magnetic substance) is incorporated passes between the magnetic shielding materials and a magnetic field of an external disturbance is blocked, a magnetic flux emitted by the broken needle incorporated into the product converges toward the magnetic shielding materials, and residual magnetization of the broken needle is detected using the magnetic sensor.

[Patent Document 1] Japanese Unexamined Patent Publication No. H11-72479

SUMMARY

According to the technology described in Patent Document 1, upper and lower magnetic shielding materials absorb radiation of a magnetic flux emitted by a broken needle, and the magnetic flux converges up and down. Consequently, a magnetic flux which enters a magnetic sensor serving as detection means can be strengthened. At the same time, the magnetic shielding materials are shielded from (absorb) a magnetic field (external disturbance) from the outside. The magnetic sensor detects only a magnetic field from a test object inside a product. Incidentally, as an external disturbance, this technology focuses on a magnetic field from the outside. However, an external disturbance included in an output of a sensor is not limited to only a magnetic field from the outside. For example, vibration or the like applied to the magnetic sensor may also cause an external disturbance. On the other hand, in recent years, there has been a demand for a technology in which movement of a product (article) is detected using a magnetic sensor when the article is moved or conveyed. Considering factors of various kinds of external disturbances, it is difficult to remove an external disturbance included in an output from a sensor.

The present disclosure provides an article movement detection system and a method for detecting article movement, in which an external disturbance included in an output from a sensor can be removed and movement of an article can be detected accurately.

According to an aspect of the present disclosure, there is provided an article movement detection system configured to detect movement of an article having a characteristic for detection. The article movement detection system includes a first sensor and a second sensor configured to be disposed facing a movement path of the article and to be capable of individually detecting that the article has moved on the basis of the characteristic, and a detection unit configured to detect movement of the article on the basis of a first output being output from the first sensor and a second output being output from the second sensor. The first sensor and the second sensor are disposed at different positions in a moving direction of the article, and a first detection signal of the first output detected in response to the article and a second detection signal of the second output detected in response to the article are output with a time lag therebetween. The detection unit is configured to detect movement of the article on the basis of the first detection signal and the second detection signal.

According to this article movement detection system, both the first sensor and the second sensor can detect that the article has moved on the movement path. The first sensor and the second sensor are disposed at different positions in the moving direction of the article. For example, when one certain (one kind of) article is conveyed by a conveying device or the like and moves along the movement path, the first detection signal and the second detection signal detected in response to the article are output with a time lag therebetween. The detection unit is configured to detect movement of the article on the basis of the first detection signal and the second detection signal. Therefore, movement of the article can be detected accurately. For example, even when two sensors are affected by an external disturbance such as vibration, detection signals detected in response to the external disturbance are output substantially at the same timing. In contrast, the first detection signal and the second detection signal are output with a time lag (timing delay) therebetween. Therefore, it is easy to distinguish the first detection signal and the second detection signal from detection signals generated due to other external disturbances. Thus, it is possible to remove only an external disturbance included in the first and second outputs by comparing the first output and the second output to each other, performing arithmetic operations of addition and subtraction therebetween, or the like. As a result, movement of the article can be detected accurately.

The first sensor and the second sensor are preferably disposed in directions opposite to each other. The detection unit is preferably configured to detect movement of the article on the basis of a result of addition processing in which the second output is added to the first output. In this case, it is assumed that outputs having opposite signs (in other words, having opposite phases) in terms of positive and negative can be obtained from the first sensor and the second sensor disposed in directions opposite to each other in response to an external disturbance. According to this addition processing, it is possible to easily remove (cancel) an external disturbance included in the first and second outputs.

The first sensor and the second sensor are preferably disposed in the same direction. The detection unit is preferably configured to detect movement of the article on the basis of a result of subtraction processing in which the second output is subtracted from the first output. In this case, it is assumed that outputs having the same signs (in other words, having the same phases) in terms of positive and negative can be obtained from the first sensor and the second sensor disposed in the same direction in response to an external disturbance. According to this subtraction processing, it is possible to easily remove (cancel) an external disturbance included in the first and second outputs.

The first output and the second output are preferably able to be expressed in a first sine wave of a time related to movement of the article and a second sine wave of a time related to an external disturbance, respectively. The detection unit is preferably configured to perform arithmetic operation processing such that a value of the second sine wave is reduced with respect to the first output and the second output and detect movement of the article on the basis of a result of the arithmetic operation processing. In this case, the first detection signal and the second detection signal are included in the first sine wave. Arithmetic operation processing is performed such that the value of the second sine wave is reduced with respect to the first output and the second output. Therefore, an external disturbance included in the first and second outputs is reliably removed. As a result, it is easy to identify the first detection signal and the second detection signal.

The article preferably contains a magnetic substance and has magnetism as the characteristic for detection due to the magnetic substance which has been magnetized. The first sensor and the second sensor are preferably magnetic sensors. In this case, movement of the article having magnetism is detected using the magnetic sensors. Even when magnetism is comparatively weak, the first sensor and the second sensor individually output the first detection signal and the second detection signal with a time lag therebetween. Therefore, it is possible to remove only an external disturbance.

The article preferably includes a permanent magnet and has magnetism as the characteristic due to the permanent magnet. The first sensor and the second sensor are preferably magnetic sensors. In this case, movement of the article having magnetism is detected by the magnetic sensors. Magnetism becomes comparatively strong using a permanent magnet. Therefore, it is easy to distinguish a detection signal generated due to an external disturbance from the first detection signal and the second detection signal.

The article preferably includes an IC tag of an RFID and is capable of performing wireless communication with the outside via electromagnetic waves as the characteristic. The first sensor and the second sensor are preferably antennas of RFID readers. In this case, movement of the IC tag inside the article is detected by the two antennas disposed at different positions in the moving direction of the article. The two antennas respectively output the first detection signal and the second detection signal with a time lag therebetween. Therefore, it is possible to remove only an external disturbance.

According to another aspect of the present disclosure, there is provided a method for detecting article movement, in which movement of an article having a characteristic for detection is detected. The method for detecting article movement includes using a first sensor and a second sensor disposed facing a movement path of the article, disposed at different positions in a moving direction of the article, and capable of individually detecting that the article has moved on the basis of the characteristic; an acquiring step of acquiring a first output being output from the first sensor and a second output being output from the second sensor, in which a first detection signal of the first output detected in response to the article and a second detection signal of the second output detected in response to the article are output with a time lag therebetween; and a detecting step of detecting movement of the article on the basis of the first detection signal of the first output and the second detection signal of the second output. According to this method for detecting article movement as well, operations and effects similar to those of the article movement detection system described above are exhibited. That is, movement of the article is detected on the basis of the first detection signal and the second detection signal output with a time lag therebetween. Therefore, it is possible to remove only an external disturbance and accurately detect movement of the article.

According to some aspects of the present disclosure, it is possible to remove an external disturbance included in an output from a sensor and accurately detect movement of an article.

## BRIEF DESCRIPTION OF THE DRAWINGS

FIG. 1 is a view showing an example of a system in which an article movement detection system according to the present disclosure is applied.

FIG. 2 is a block diagram showing a schematic configuration of the article movement detection system in FIG. 1.

FIG. 3 is a view showing a configuration of a circuit including a sensor in the article movement detection system in FIG. 2.

FIG. 4 is a view of comparison between a first output from a first sensor and a second output from a second sensor.

FIG. 5 is a flowchart showing processing executed by the article movement detection system.

FIG. 6A and FIG. 6B are views showing results of first verification performed by applying only movement of an article.

FIG. 7A and FIG. 7B are views showing results of second verification performed by applying only an external disturbance.

FIG. 8A and FIG. 8B are views showing results of third verification performed by applying movement of the article and an external disturbance.

FIG. 9A and FIG. 9B are views showing results of fourth verification performed by applying movement of the article and an external disturbance.

FIG. 10A and FIG. 10B are views showing results of fifth verification performed by applying only an external disturbance.

FIG. 11A and FIG. 11B are views showing results of sixth verification performed by applying movement of the article and an external disturbance.

## DETAILED DESCRIPTION

Hereinafter, an embodiment of the present invention will be described with reference to the drawings. In description of the drawings, the same reference signs are applied to the same elements, and duplicate description will be omitted.

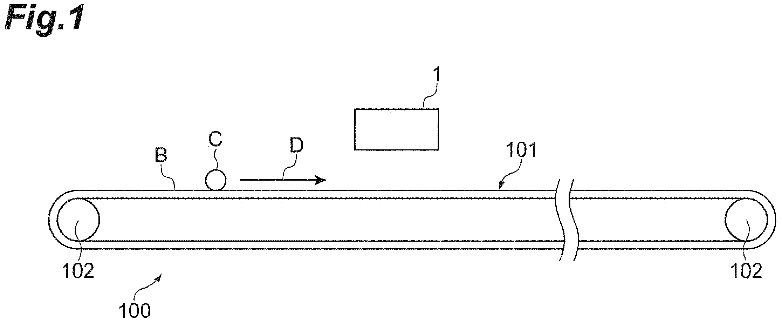

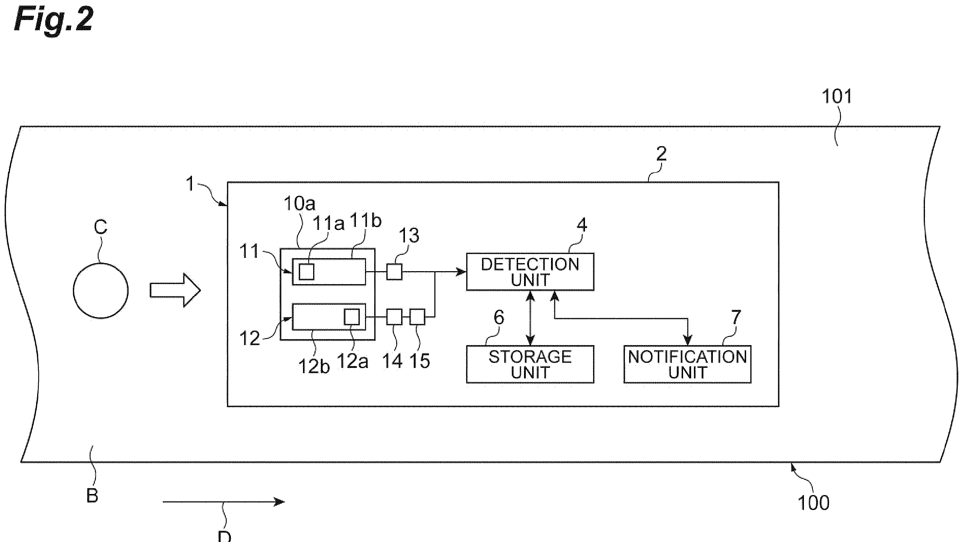

With reference to FIGS. 1 and 2, the embodiment of the present disclosure will be described. For example, an article movement detection system 1 of the present embodiment is a system detecting movement of an article C which is conveyed by a conveying device 100. The article C (target) is not particularly limited. The article C has a characteristic for detection. The article C has magnetism as this characteristic, for example. The article C may include a magnetic substance. The magnetic substance may be magnetized in advance. The magnetic substance inside the article C may be magnetized by passing through the inside of a magnetic field before it passes through the article movement detection system 1. In such a case, a device for applying a magnetic field may be installed in the conveying device 100. The magnetism intensity (magnetic flux density) of the article C may be suitably changed depending on the kind (the material, the size, and the like) of the article C and is approximately 0.5 mT (5G), for example. The magnetism intensity of the article C may be within a range of approximately 0.2 to 0.8 mT, for example.

For example, the article movement detection system 1 is installed to face a conveying surface B of the conveying device 100. The article movement detection system 1 can detect movement of the article C if it is a certain moving article C. One article C may be conveyed apart from other articles C in a first direction D, or a plurality of articles C may be placed close to each other and conveyed on the conveying surface B. The conveying speed (moving speed) of the article C is not particularly limited. An apparatus or a system in which the article movement detection system 1 is applied is not limited to the conveying device 100. The article movement detection system 1 is fixed at a predetermined position. For example, the article movement detection system 1 may be affected by oscillation or vibration. An external factor such as oscillation or vibration is detected by the article movement detection system 1 as an external disturbance.

For example, the conveying device 100 includes a belt conveyor 101, a plurality of rollers 102 for causing the belt conveyor 101 to travel, and a drive source (not shown in the diagrams). Any one of the rollers 102 may serve as a driving roller, and the other rollers may serve as driven rollers. The upper surface of the belt conveyor 101 is the conveying surface B on which the article C is placed. The article C is placed on the conveying surface B when conveyed and moves along the movement path on the conveying surface B. A conveying direction of the conveying device 100, that is, a first direction (moving direction) D in which the article C moves is linear, for example. The conveying device 100 is disposed close to the conveying surface B such that a first magnetic sensor 11a and a second magnetic sensor 12a inside thereof can detect that the article C has moved on the basis of magnetism of the article C.

As shown in FIG. 2, the article movement detection system 1 includes a sensor unit 10 fixed at a particular position inside a casing 2, a detection unit 4 detecting movement of the article C on the basis of a signal output from the sensor unit 10, a storage unit 6 storing detection results of the detection unit 4, and a notification unit 7 issuing a notification to an operator or the like. For example, the detection unit 4 is configured to include a computer constituted of hardware such as a central processing unit (CPU), a read only memory (ROM), and a random access memory (RAM); and software such as a program stored in the ROM. The notification unit 7 may be a speaker, for example, issuing an auditory notification, may be a vibrator, for example, issuing a tactile notification, or may be a display, for example, issuing a visual notification.

The sensor unit 10 is a part for detecting the intensity of a magnetic field. The sensor unit 10 has a first sensor unit 11 and a second sensor unit 12. The first sensor unit 11 and the second sensor unit 12 are arranged inside the casing 2 in a second direction (for example, a width direction of the belt conveyor 101) orthogonal to the first direction D and a thickness direction of the casing 2. The first sensor unit 11 and the second sensor unit 12 are adjacent to each other in the second direction. For example, the first sensor unit 11 and the second sensor unit 12 are mounted on a substrate 10a which is fixed inside the casing 2. For example, the first sensor unit 11 and the second sensor unit 12 are the same component, and therefore component sharing is promoted.

The first sensor unit 11 includes a first magnetic sensor (first sensor) 11a which is mounted on a rectangular substrate 11b. Similarly, the second sensor unit 12 includes a second magnetic sensor (second sensor) 12a which is mounted on a rectangular substrate 12b. The first magnetic sensor 11a is a sensor capable of detecting that the article C has moved along the movement path of the conveying device 100 on the basis of magnetism of the article C. Similarly, the second magnetic sensor 12a is a sensor capable of detecting that the article C has moved along the movement path of the conveying device 100 on the basis of magnetism of the article C. The first magnetic sensor 11a and the second magnetic sensor 12a are fixed inside the casing 2. The type of these magnetic sensors is not particularly limited. However, for example, magnetism impedance elements (MI sensors) or magnetoresistive effect elements (MR sensors such as TMR sensors) are used. Furthermore, coils, Hall elements, GSR sensors, Wiegand wires, flux gate sensors, optical pumping magnetometers, diamond nitrogen-vacancy center elements, Faraday elements (magneto-optic elements), proton magnetometers (magnetic resonance sensors), electrodynamic magnetic sensors (charged particle rays), superconducting quantum interference devices (SQUIDs), or the like may be used. As the magnetic sensors, it is favorable to use sensors capable of performing low power wide area (LPWA) communication. In addition, the magnetic sensors may be selected from the viewpoint of a communication range or power consumption.

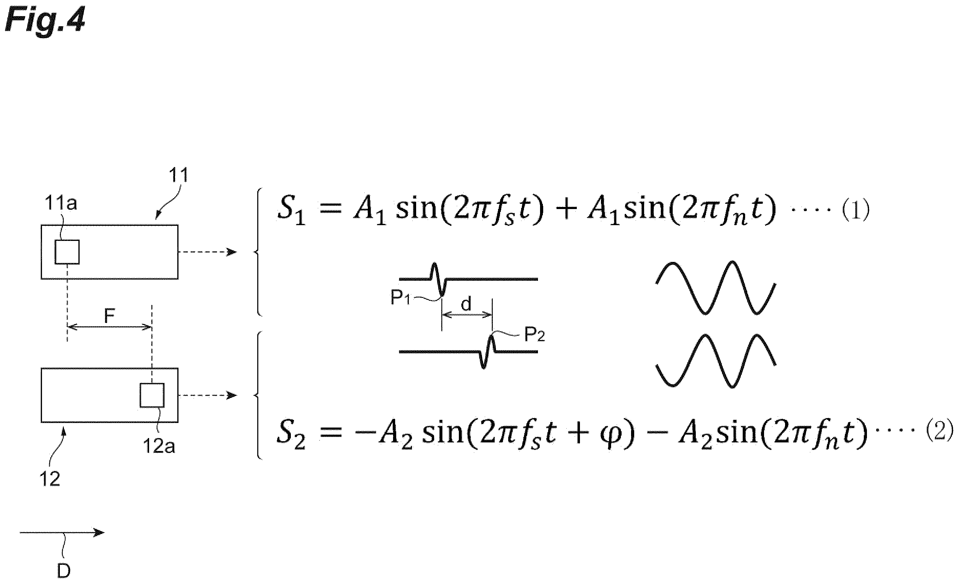

In the sensor unit 10, the distance between the first magnetic sensor 11a and the conveying surface B and the distance between the second magnetic sensor 12a and the conveying surface B are equivalent to each other, for example. Both the substrate 11b and the substrate 12b are installed such that their long sides are parallel to the first direction D. Both the substrate 11b and the substrate 12b are installed such that their short sides are parallel to the second direction. Here, the second sensor unit 12 is installed such that it is inverted vertically (in the first direction D) with respect to the first sensor unit 11. In other words, the second sensor unit 12 is disposed point-symmetrically with the first sensor unit 11 with respect to an intermediate point between the first and second sensor units 11 and 12. Due to this configuration, the second magnetic sensor 12a of the second sensor unit 12 is positioned on a downstream side of the first magnetic sensor 11a of the first sensor unit 11 in the moving direction of the article C. In other words, the disposition of the second magnetic sensor 12a is shifted in the first direction D with respect to the first magnetic sensor 11a. The first magnetic sensor 11a and the second magnetic sensor 12a are disposed at different positions in the first direction D. A uniform gap F (refer to FIG. 4) is formed between the first magnetic sensor 11a and the second magnetic sensor 12a in the first direction D. The second magnetic sensor 12a is disposed point-symmetrically with the first magnetic sensor 11a with respect to an intermediate point between the first and second magnetic sensors 11a and 12a. A predetermined circuit (wiring) is formed on the substrate 11b and the substrate 12b.

As described above, the first magnetic sensor 11a and the second magnetic sensor 12a are disposed in directions opposite to each other. The wording "a direction of a sensor" is based on a direction of the sensitivity of a sensor. Outputs having opposite signs in terms of positive and negative (in other words, outputs having opposite phases) are obtained from the first magnetic sensor 11a and the second magnetic sensor 12a which are disposed in directions opposite to each other with respect to the same external factor (a change in magnetic field, an external disturbance, or the like).

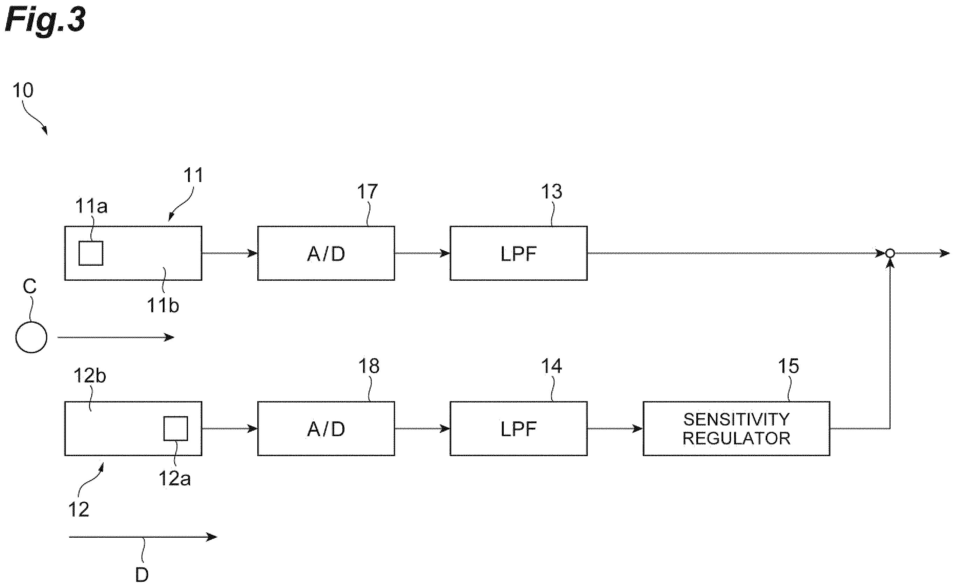

As shown in FIGS. 2 and 3, the article movement detection system 1 includes an AD converter 17 connected to an output end of the first sensor unit 11, a low-pass filter (hereinafter, an LPF 13) connected to an output end of the AD converter 17, an AD converter 18 connected to an output end of the second sensor unit 12, an LPF 14 connected to an output end of the AD converter 18, and a sensitivity regulator 15 connected to an output end of the LPF 14. These are fixed inside the casing 2. The LPF 13 and the LPF 14 are the same component and allow a frequency component having a frequency of 20 Hz or lower to pass through, for example. In FIG. 2, illustration of the AD converters 17 and 18 is omitted. The AD converter 17 and the AD converter 18 convert analog signals output from the first sensor unit 11 and the second sensor unit 12 into digital signals. The sensitivity regulator 15 regulates an output from the AD converter 17 (first sensor unit 11) and an output from the AD converter 18 (second sensor unit 12) at the same level. The output level of the sensitivity regulator 15 is regulated at the time of an initial set-up, for example. In the sensor unit 10, an output from the LPF 13 and an output from the sensitivity regulator 15 are added. In the present embodiment, a voltage output from the LPF 13 corresponds to a first output, and a voltage output from the sensitivity regulator 15 corresponds to a second output. However, the sensitivity regulator 15 can be omitted. When the sensitivity regulator 15 is omitted, a voltage output from the LPF 14 corresponds to the second output. Both or any one of the LPF 13 and the LPF 14 can also be omitted.

Subsequently, with reference to FIG. 4, a relationship between the first output being output from the first magnetic sensor 11a (first sensor unit 11) and the second output being output from the second magnetic sensor 12a (second sensor unit 12) will be described. When the first magnetic sensor 11a and the second magnetic sensor 12a are disposed in an inverted manner as described above, a time difference (that is, a timing delay) is generated in detection of the article C. On the other hand, no time difference is generated in an external disturbance caused by vibration or the like of the system. A time difference mentioned here can also be referred to as a phase difference in Expression (1) and Expression (2) shown in FIG. 4. Expression (1) and Expression (2) have the following factors.

$S_1$:     First output from first magnetic sensor 11a
$S_2$:     Second output from second magnetic sensor 12a
$A_1$:     Sensitivity of first magnetic sensor 11a
$A_2$:     Sensitivity of second magnetic sensor 12a
$F_s$:     Frequency of article motion
$F_n$:     Frequency of external disturbance motion
$\varphi$:     Phase difference
T:     Time

As shown in FIG. 4, the second output of the second magnetic sensor 12a has a phase opposite to that of the first output of the first magnetic sensor 11a. Further, due to the foregoing gap F, the second magnetic sensor 12a is configured such that a second peak output $P_2$ which is a peak value of the second output generated due to the article C is output later than a first peak output $P_1$ which is a peak value of the first output generated due to the article C by a phase difference d when the article C is conveyed and moved.

The first peak output $P_1$ is a first detection signal of the first output detected in response to the article C. The second peak output $P_2$ is a second detection signal of the second output detected in response to the article C. In the article movement detection system 1, the first peak output $P_1$ (first detection signal) and the second peak output $P_2$ (second detection signal) are output with a time lag therebetween.

The detection unit 4 of the article movement detection system 1 detects passing (movement) of the article C on the basis of the first output being output from the first magnetic sensor 11a and the second output being output from the second magnetic sensor 12a.

More specifically, when the first output $S_1$ output from the first sensor unit 11 of the article movement detection system 1 and the second output $S_2$ output from the second sensor unit 12 are added, an output of an external disturbance (second members in Expressions (1) and (2) shown in FIG. 4) is expressed by the following Expression (3). In Expression (3), as an example, for a balance between the sensitivity $A_1$ of the first magnetic sensor 11a and the sensitivity $A_2$ of the second magnetic sensor 12a, the second output $S_2$ is converted. The second output $S_2$ after conversion is expressed as $S_2'$. The factor $S_{12}$ is a ratio of the sensitivity $A_1$ of the first magnetic sensor 11a to the sensitivity $A_2$ of the second magnetic sensor 12a used in this conversion (that is, a relationship of $A_1=S_{12}A_2$ and a relationship of $S_2'=S_{12}S_2$ are established).

$$
\begin{aligned}
S_1 + S_2' &= A_1 \sin(2\pi f_n t) - S_{12} A_2 \sin(2\pi f_n t) \\
&= A_1 \sin(2\pi f_n t) - A_1 \sin(2\pi f_n t) \\
&= 0 \qquad\qquad\qquad\qquad \cdots (3)
\end{aligned}
$$

In this manner, the value of an output of an external disturbance is canceled (becomes zero) by balancing the sensitivity.

In addition, when the first output $S_1$ output from the first sensor unit 11 of the article movement detection system 1 and the second output $S_2$ output from the second sensor unit 12 are added, an output of article detection (first members in Expressions (1) and (2) shown in FIG. 4) is expressed by the following Expression (4). In Expression (4) as well, as an example, for a balance between the sensitivity $A_1$ of the first magnetic sensor 11a and the sensitivity $A_2$ of the second magnetic sensor 12a, the second output $S_2$ is converted.

$$S_1 + S_2{}' = A_1 \sin(2\pi f_n t) - S_{12} A_2 \sin(2\pi f_n t + \varphi)$$

$$= A_1 \sin(2\pi f_n t) - A_1 \sin(2\pi f_n t + \varphi) \qquad \because A = \sqrt{2(1 - \cos(\varphi))}$$

$$= A \sin(2\pi f_n t + \theta) \qquad\qquad \theta = tan^{-1}\frac{-\sin\varphi}{1 - \cos\varphi} \qquad \cdots (4)$$

In this manner, even when the sensitivity $A_1$ of the first magnetic sensor 11a and the sensitivity $A_2$ of the second magnetic sensor 12a are balanced, there is a phase difference in the outputs of article detection. Therefore, a result obtained by performing addition as in Expression (3) does not become zero. On this wise, movement (passing) of the article C can be detected by adding the first output $S_1$ and the second output $S_2$ while an output of an external disturbance is reduced. A method for balancing the sensitivity $A_1$ of the first magnetic sensor 11a and the sensitivity $A_2$ of the second magnetic sensor 12a is not limited to the foregoing method. The first output $S_1$ may be converted, or both the first output $S_1$ and the second output $S_2$ may be converted such that they have equivalent values. When the sensitivity $A_1$ of the first magnetic sensor 11a and the sensitivity $A_2$ of the second magnetic sensor 12a are equivalent or substantially equivalent to each other, the conversion coefficient $S_{12}$ may be omitted.

As described above, the first output $S_1$ and the second output $S_2$ can be expressed in a first sine wave (first members of Expressions (1) and (2) shown in FIG. 4) of a time related to movement of the article C and a second sine wave (second members of Expressions (1) and (2) shown in FIG. 4) of a time related to an external disturbance, respectively. The detection unit 4 performs arithmetic operation processing such that the value of the second sine wave is reduced (canceled) with respect to the first output $S_1$ and the second output $S_2$ and detects movement of the article C on the basis of a result of the arithmetic operation processing. More specifically, the phase difference $\varphi$ is present in the first sine wave between the first output $S_1$ and the second output $S_2$, but no phase difference is present in the second sine wave. The detection unit 4 detects the first peak output $P_1$ included in the first sine wave of the first output $S_1$ and the second peak output $P_2$ included in the first sine wave of the second output $S_2$ through addition processing of the first output $S_1$ and the second output $S_2$ or subtraction processing of the second output $S_2$ with respect to the first output $S_1$.

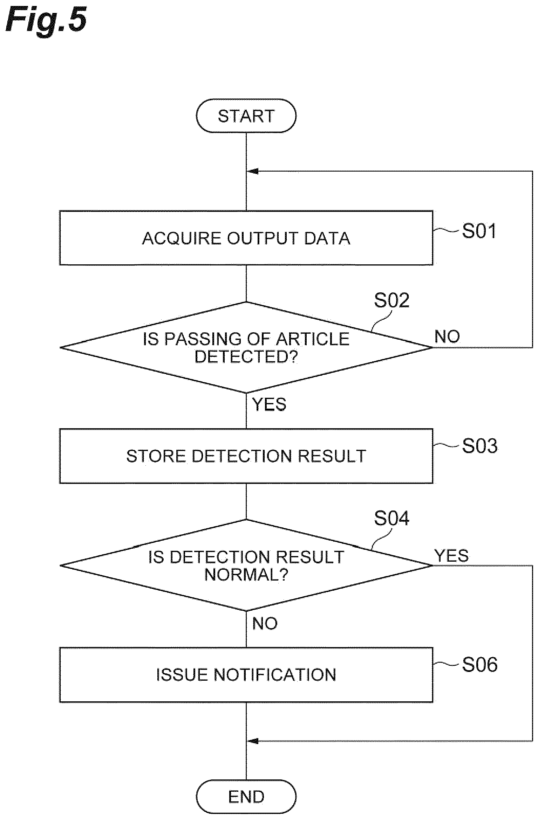

Subsequently, with reference to the flowchart in FIG. 5, processing executed by the article movement detection system 1, that is, a method for detecting article movement will be described. As shown in FIG. 5, the detection unit 4 of the article movement detection system 1 inputs data (so-called differential processing data) in which the first output and the second output are added after they have gone through the LPF 13, the LPF 14, and the sensitivity regulator 15 (Step S01). That is, the detection unit 4 acquires the first output being output from the first magnetic sensor 11a and the second output being output from the second magnetic sensor 12a (acquiring step). Here, when the first peak output $P_1$ is included in the first output and the second peak output $P_2$ is included in the second output, the first peak output $P_1$ and the second peak output $P_2$ are output with a time lag therebetween. Next, the detection unit 4 of the article movement detection system 1 determines whether or not passing of the article C has been detected (Step S02). For example, the detection unit 4 stores a predetermined threshold related to an output voltage and determines whether or not passing of the article C has been detected on the basis of whether or not an output voltage exceeding the threshold has been detected within a predetermined time. This threshold is set to be smaller than output voltages corresponding to the first peak output $P_1$ and the second output $S_2$ described above. When an output voltage exceeding the threshold has been detected within a predetermined time, the detection unit 4 determines that passing of the article C has been detected (Step S02; YES). The detection unit 4 detects passing of the article C on the basis of the first peak output $P_1$ of the first output and the second peak output $P_2$ of the second output (detecting step). When an output voltage exceeding the threshold has not been detected within a predetermined time, the detection unit 4 determines that passing of the article C has not been detected (Step S02; NO), and the processing returns to Step S01.

When it is determined in Step S02 that passing of the article C has been detected, the detection unit 4 of the article movement detection system 1 stores information indicating that passing of the article C has been detected and a detection time thereof in the storage unit 6 as detection results (Step S03).

The detection unit 4 of the article movement detection system 1 determines whether or not the detection results are normal (Step S04). For example, the detection unit 4 calculates the number of articles C which have passed through within a predetermined time range and determines whether the number thereof is within a range of a number set in advance. When it is determined that the detection results are normal (Step S04; YES), the detection unit 4 ends the processing. When it is determined that the detection results are not normal (Step S04; NO), the detection unit 4 controls the notification unit 7 and issues a notification to an operator or the like (Step S06).

Processing of detecting the moving article C is performed according to a series of processing described above.

According to this article movement detection system 1, both the first magnetic sensor 11a and the second magnetic sensor 12a can detect the article C which has moved on the conveying surface B. The first magnetic sensor 11a and the second magnetic sensor 12a are disposed at different positions in the first direction D. When one certain (one kind of) article C is conveyed and moves along the movement path by the conveying device 100, the first detection signal and the second detection signal detected in response to the article C are output with a time lag therebetween. The detection unit 4 detects movement of the article C on the basis of the first detection signal and the second detection signal. Therefore, movement of the article C can be detected accurately. For example, even when two sensors 11a and 12a are affected by an external disturbance such as vibration, detection signals detected in response to the external disturbance are output substantially at the same timing. In contrast, the first detection signal and the second detection signal are output with a time lag (timing delay) therebetween. Therefore, it is easy to distinguish the first detection signal and the second detection signal from detection signals generated due to other external disturbances. Thus, it is possible to remove only an external disturbance included in the first and second outputs by comparing the first output and the second output to each other, performing arithmetic operations of addition and subtraction therebetween, or the like. As a result, movement of the article C can be detected accurately. The article movement detection system 1 can accurately detect passing of the article C even under an environment such as a factory in which vibration is likely to be generated.

The first magnetic sensor 11a and the second magnetic sensor 12a are disposed in directions opposite to each other. The detection unit 4 detects movement of the article C on the basis of a result of addition processing in which the second output is added to the first output. Outputs having opposite signs (in other words, having opposite phases) in terms of positive and negative can be obtained from the first magnetic sensor 11a and the second magnetic sensor 12a in response to an external disturbance. According to this addition processing, it is possible to easily remove (cancel) an external disturbance included in the first and second outputs.

The first peak output $P_1$ and the second peak output $P_2$ are included in the first sine wave. Arithmetic operation processing is performed such that the value of the second sine wave is reduced with respect to the first output $S_1$ and the second output $S_2$. Therefore, an external disturbance included in the first output $S_1$ and the second output $S_2$ is reliably removed. As a result, it is easy to identify the first peak output $P_1$ and the second peak output $P_2$.

The article C contains a magnetic substance which has been magnetized and has magnetism as a characteristic for detection due to the magnetic substance which has been magnetized. Movement of the article C having magnetism is detected by the first magnetic sensor 11a and the second magnetic sensor 12a. Even when magnetism is comparatively weak, the first magnetic sensor 11a and the second magnetic sensor 12a individually output the first detection signal and the second detection signal with a time lag therebetween. Therefore, it is possible to remove only an external disturbance.

Subsequently, verification of detection accuracy of the article C was attempted using a test system including the first magnetic sensor 11a and the second magnetic sensor 12a. The magnetic sensors used in the test were magnetism impedance element (MI sensor) sensors. In this test, a configuration similar to that (refer to FIG. 3) of the sensor unit 10 in the foregoing embodiment was adopted, and vibration was applied to both of the sensors as an external disturbance in a direction horizontal to or a direction perpendicular to the substrate 10a of the sensor unit 10. Meanwhile, a test body which had magnetism and was produced in a simulative manner was moved in the first direction D at a speed of approximately 1.2 cm/sec. This test body corresponds to the article C in the foregoing embodiment.

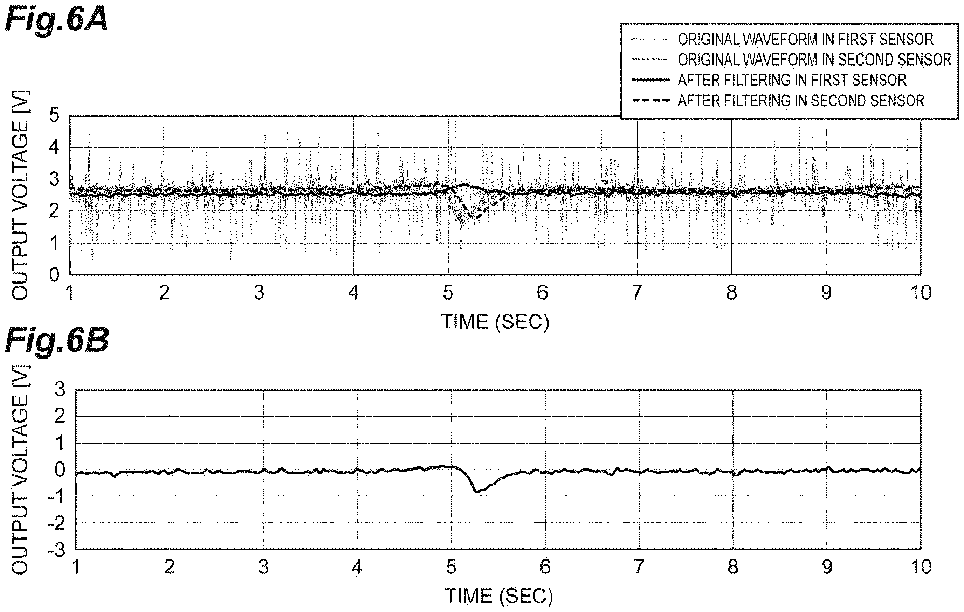

Each of FIGS. 6A and 6B is a view showing a result of first verification performed by applying only movement of the test body. No external disturbance was applied. As shown in FIG. 6A, noise was ascertained in a waveform before filtering, and a peak output generated due to the test body was obtained in both sensors in a waveform after filtering. As a result, as shown in FIG. 6B, a detection signal of the test body was clearly obtained in differential processing data (data after addition).

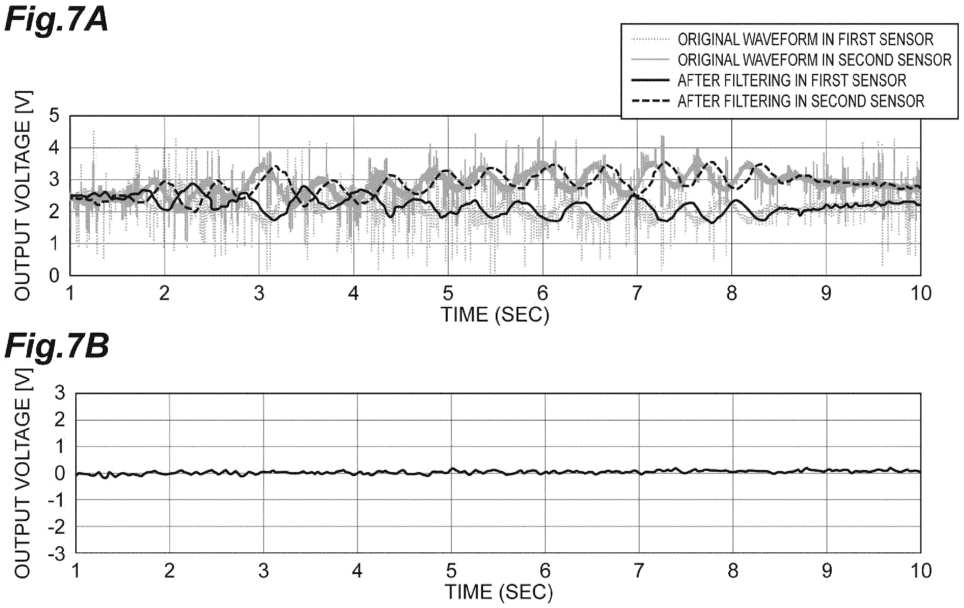

Each of FIGS. 7A and 7B is a view showing a result of second verification performed by applying only an external disturbance in a horizontal direction of the sensors. No movement of the test body was applied. As shown in FIG. 7A, noise was ascertained in a waveform before filtering, and a periodic waveform caused by an external disturbance was obtained in a waveform after filtering. As a result, as shown in FIG. 7B, a canceled flat signal was obtained in the differential processing data (data after addition).

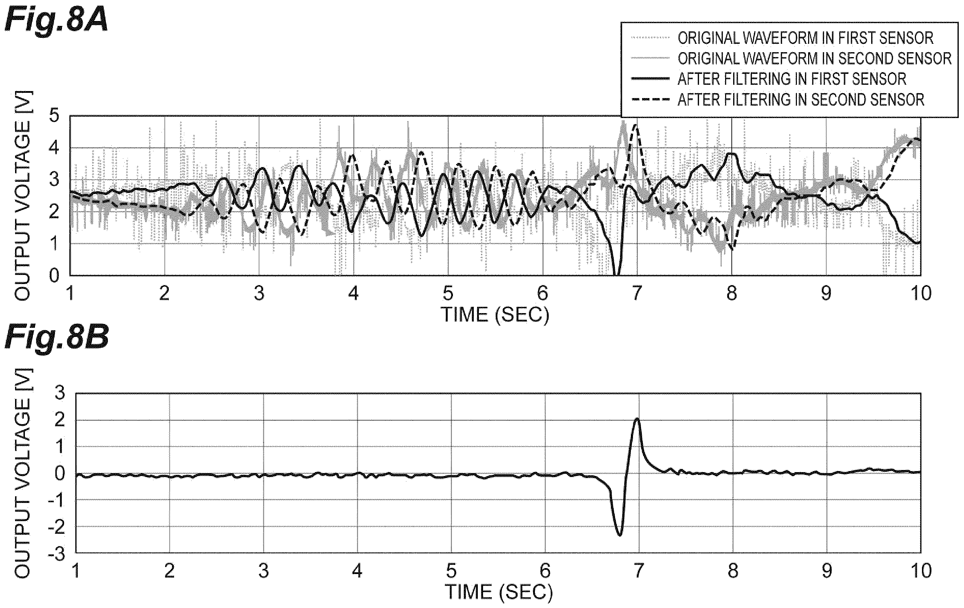

Each of FIGS. 8A and 8B is a view showing a result of third verification performed by applying movement of the test body and an external disturbance in the horizontal direction of the sensors. As shown in FIG. 8A, noise was ascertained in a waveform before filtering, and a periodic waveform caused by an external disturbance and a peak output generated due to the test body were obtained in a waveform after filtering. As a result, as shown in FIG. 8B, a detection signal of the test body was clearly obtained in the differential processing data (data after addition).

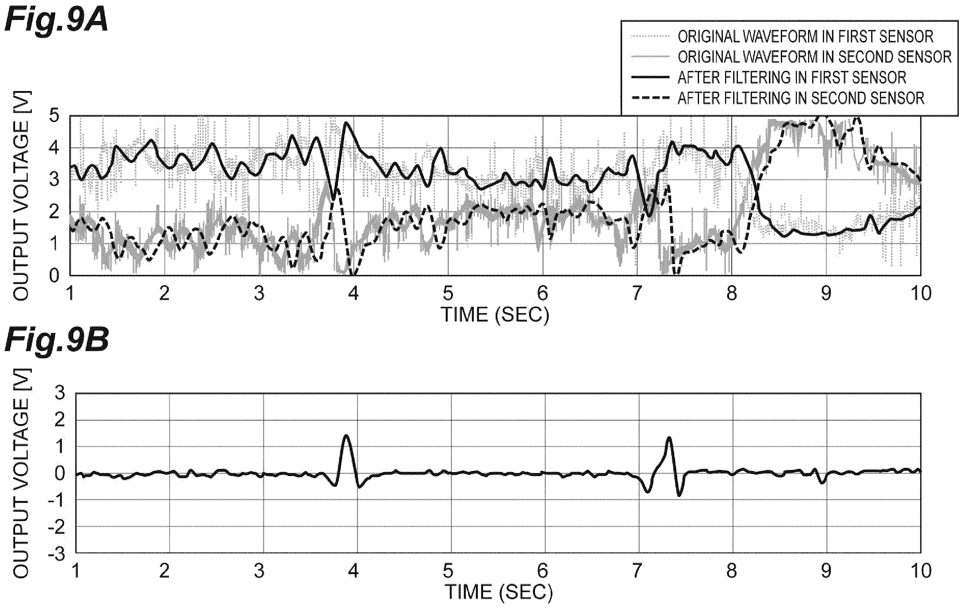

Each of FIGS. 9A and 9B is a view showing a result of fourth verification performed by applying movement of the test body twice and applying an external disturbance in the horizontal direction of the sensors. As shown in FIG. 9A, noise was ascertained in a waveform before filtering, and a periodic waveform caused by an external disturbance and a peak output generated due to the test body were obtained in a waveform after filtering. As a result, as shown in FIG. 9B, a detection signal of the test body was clearly obtained twice in the differential processing data (data after addition).

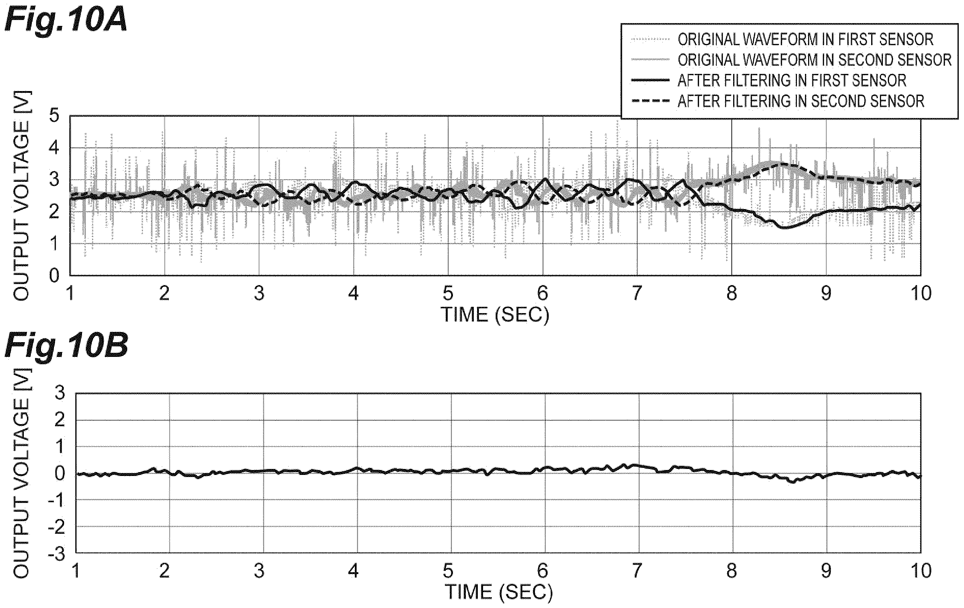

Each of FIGS. 10A and 10B is a view showing a result of fifth verification performed by applying only an external disturbance in the perpendicular direction of the sensors. No movement of the test body was applied. As shown in FIG. 10A, noise was ascertained in a waveform before filtering, and a periodic waveform caused by an external disturbance was obtained in a waveform after filtering. As a result, as shown in FIG. 10B, a canceled flat signal was obtained in the differential processing data (data after addition).

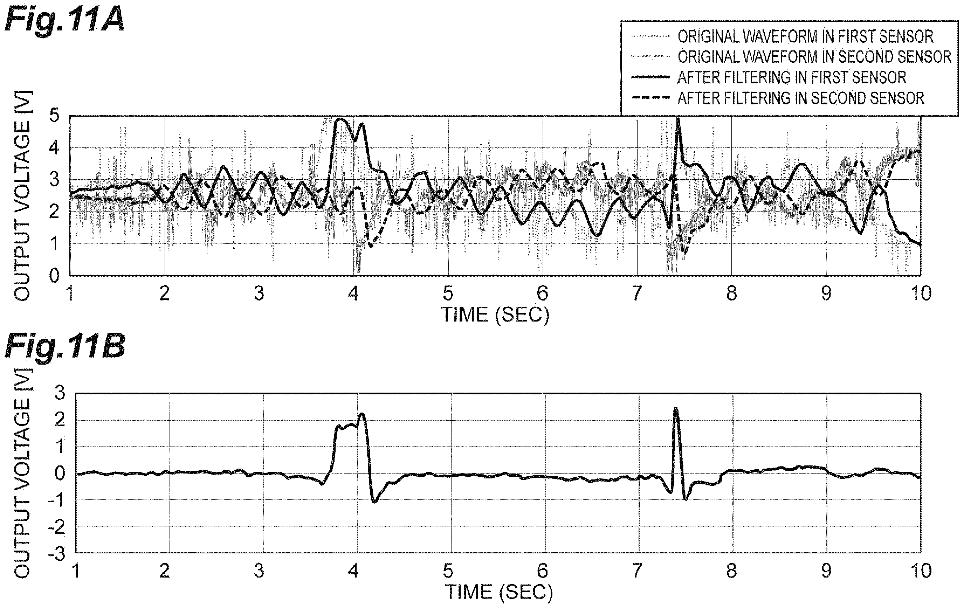

Each of FIGS. 11A and 11B is a view showing a result of sixth verification performed by applying movement of the test body twice and applying an external disturbance in the perpendicular direction of the sensors. As shown in FIG. 11A, noise was ascertained in a waveform before filtering, and a periodic waveform caused by an external disturbance and a peak output generated due to the test body were obtained in in a waveform after filtering. As a result, as shown in FIG. 11B, a detection signal of the test body was clearly obtained twice in the differential processing data (data after addition).

Hereinabove, the embodiment of the present invention has been described, and the present invention is not limited to the foregoing embodiment. For example, the first sensor and the second sensor may be disposed in the same direction. Further, the detection unit may detect movement of an article on the basis of a result of subtraction processing in which the second output is subtracted from the first output. In this case, it is assumed that outputs having the same signs (in other words, having the same phases) in terms of positive and negative can be obtained from the first sensor and the second sensor disposed in the same direction in response to an external disturbance. According to this subtraction processing, it is possible to easily remove (cancel) an external disturbance included in the first and second outputs.

The article may include a permanent magnet and may have magnetism as the characteristic due to the permanent magnet. Further, the first sensor and the second sensor may be magnetic sensors. In this case, movement of the article having magnetism is detected by the magnetic sensors. Magnetism becomes comparatively strong using a permanent magnet. Therefore, it is easy to distinguish a detection signal generated due to an external disturbance from the first detection signal and the second detection signal.

The article may include an IC tag (or an IC chip) of an RFID and may be capable of performing wireless communication with the outside via electromagnetic waves as the characteristic for detection. Further, the first sensor and the second sensor may be antennas of RFID readers. The IC tag is built into the article. The IC tag may be a passive tag. The IC tag may be an active tag or a semi-active tag. The readers have a configuration according to the type of the IC tag. The readers may include the detection unit of the present invention. The detection unit may be separated from the reader. The detection unit may be installed outside the casing 2. When the RFID is applied, movement of the IC tag inside the article is detected by the two antennas disposed at different positions in the moving direction of the article. The two antennas respectively output the first detection signal and the second detection signal with a time lag therebetween. Therefore, it is possible to remove only an external disturbance.

The sensitivity regulator 15 may be installed for the first sensor unit 11 or may be installed for both the first sensor unit 11 and the second sensor unit 12. The sensitivity regulator 15 may be omitted.

The article may be medicine taken by a patient. In such a case, the article movement detection system has a form of a wearable device and is attached to the body of the patient, for example. Movement of medicine, such as a pill or a capsule, inside the body (for example, the gullet) of the patient can be detected by the article movement detection system which the patient has worn. Consequently, dosage management can be performed.

REFERENCE SIGNS LIST

1 Article movement detection system
2 Casing
4 Detection unit
6 Storage unit
7 Notification unit
10 Sensor unit
10a Substrate
11 First sensor unit
11a First magnetic sensor (first sensor)
12 Second sensor unit
12a Second magnetic sensor (second sensor)
13 LPF
14 LPF
15 Sensitivity regulator
C Article
D First direction (moving direction)

**Claims**

1.  An article movement detection system configured to detect movement of an article having a characteristic for detection, the article movement detection system comprising:

    a first sensor and a second sensor configured to be disposed facing a movement path of the article and to be capable of individually detecting that the article has moved on the basis of the characteristic; and
    a detection unit configured to detect movement of the article on the basis of a first output being output from the first sensor and a second output being output from the second sensor,
    wherein the first sensor and the second sensor are disposed at different positions in a moving direction of the article, and a first detection signal of the first output detected in response to the article and a second detection signal of the second output detected in response to the article are output with a time lag therebetween, and
    wherein the detection unit is configured to detect movement of the article on the basis of the first detection signal and the second detection signal.

2.  The article movement detection system according to claim 1, wherein

    the first sensor and the second sensor are disposed in directions opposite to each other, and
    the detection unit is configured to detect movement of the article on the basis of a result of addition processing in which the second output is added to the first output.

3.  The article movement detection system according to claim 1, wherein

    the first sensor and the second sensor are disposed in the same direction, and
    the detection unit is configured to detect movement of the article on the basis of a result of subtraction processing in which the second output is subtracted from the first output.

4.  The article movement detection system according to any one of claims 1 to 3, wherein

    the first output and the second output are able to be expressed in a first sine wave of a time related to movement of the article and a second sine wave of a time related to an external disturbance respectively, and
    the detection unit is configured to perform arithmetic operation processing such that a value of the second sine wave is reduced with respect to the first output and the second output and detect movement of the article on the basis of a result of the arithmetic operation processing.

5.  The article movement detection system according to any one of claims 1 to 4, wherein

    the article contains a magnetic substance and has magnetism as the characteristic due to the magnetic substance which has been magnetized, and
    the first sensor and the second sensor are magnetic sensors.

6.  The article movement detection system according to any one of claims 1 to 4, wherein

    the article includes a permanent magnet and has magnetism as the characteristic due to the permanent magnet, and
    the first sensor and the second sensor are magnetic sensors.

7.  The article movement detection system according to any one of claims 1 to 4, wherein

    the article includes an IC tag of an RFID and is capable of performing wireless communication with the outside via electromagnetic waves as the characteristic, and
    the first sensor and the second sensor are antennas of RFID readers.

8.  A method for detecting article movement, in which movement of an article having a characteristic for detection is detected, the method comprising:

    using a first sensor and a second sensor disposed facing a movement path of the article, disposed at different positions in a moving direction of the article, and capable of individually detecting that the article has moved on the basis of the characteristic;

an acquiring step of acquiring a first output being output from the first sensor and a second output being output from the second sensor,

in which a first detection signal of the first output detected in response to the article and a second detection signal of the second output detected in response to the article are output with a time lag therebetween; and

a detecting step of detecting movement of the article on the basis of the first detection signal of the first output and the second detection signal of the second output.

Fig.1

EP 3 715 861 A1

*Fig.2*

**Fig.3**

EP 3 715 861 A1

**Fig.4**

$$S_1 = A_1 \sin(2\pi f_s t) + A_1 \sin(2\pi f_n t) \cdots (1)$$

$$S_2 = -A_2 \sin(2\pi f_s t + \varphi) - A_2 \sin(2\pi f_n t) \cdots (2)$$

# Fig.5

```
                    ┌─────────────┐
                    │    START    │
                    └─────────────┘
                           │
                           ▼
         ┌──────────────────────────────────┐
         │       ACQUIRE OUTPUT DATA         │──── S01
         └──────────────────────────────────┘
                           │
                           ▼            S02
                    ◇─────────────◇
              ┌─── IS PASSING OF ARTICLE ───┐ NO
              │       DETECTED?             │
                    ◇─────────────◇
                           │ YES
                           ▼
         ┌──────────────────────────────────┐
         │      STORE DETECTION RESULT       │──── S03
         └──────────────────────────────────┘
                           │
                           ▼            S04
                    ◇─────────────◇
                    IS DETECTION RESULT      YES
                        NORMAL?         ─────────┐
                    ◇─────────────◇             │
                           │ NO                  │
                           ▼                     │
         ┌──────────────────────────────────┐   │
         │        ISSUE NOTIFICATION         │── S06
         └──────────────────────────────────┘   │
                           │◄────────────────────┘
                           ▼
                    ┌─────────────┐
                    │     END     │
                    └─────────────┘
```

*Fig.6A*

*Fig.6B*

## Fig.7A

ORIGINAL WAVEFORM IN FIRST SENSOR
ORIGINAL WAVEFORM IN SECOND SENSOR
AFTER FILTERING IN FIRST SENSOR
AFTER FILTERING IN SECOND SENSOR

OUTPUT VOLTAGE [V]

TIME (SEC)

## Fig.7B

OUTPUT VOLTAGE [V]

TIME (SEC)

# Fig.8A

Legend:
- ORIGINAL WAVEFORM IN FIRST SENSOR
- ORIGINAL WAVEFORM IN SECOND SENSOR
- AFTER FILTERING IN FIRST SENSOR
- AFTER FILTERING IN SECOND SENSOR

OUTPUT VOLTAGE [V]

TIME (SEC)

# Fig.8B

OUTPUT VOLTAGE [V]

TIME (SEC)

EP 3 715 861 A1

Fig.9A

Legend:
- ORIGINAL WAVEFORM IN FIRST SENSOR
- ORIGINAL WAVEFORM IN SECOND SENSOR
- AFTER FILTERING IN FIRST SENSOR
- AFTER FILTERING IN SECOND SENSOR

OUTPUT VOLTAGE [V]

TIME (SEC)

Fig.9B

OUTPUT VOLTAGE [V]

TIME (SEC)

# *Fig.10A*

Legend:
- ............ ORIGINAL WAVEFORM IN FIRST SENSOR
- ———— ORIGINAL WAVEFORM IN SECOND SENSOR
- —— AFTER FILTERING IN FIRST SENSOR
- - - - AFTER FILTERING IN SECOND SENSOR

OUTPUT VOLTAGE [V] vs TIME (SEC)

# *Fig.10B*

OUTPUT VOLTAGE [V] vs TIME (SEC)

EP 3 715 861 A1

## Fig.11A

Legend:
- ORIGINAL WAVEFORM IN FIRST SENSOR
- ORIGINAL WAVEFORM IN SECOND SENSOR
- AFTER FILTERING IN FIRST SENSOR
- AFTER FILTERING IN SECOND SENSOR

OUTPUT VOLTAGE [V]

TIME (SEC)

## Fig.11B

OUTPUT VOLTAGE [V]

TIME (SEC)

EP 3 715 861 A1

Europäisches
Patentamt

European
Patent Office

Office européen
des brevets

# EUROPEAN SEARCH REPORT

**Application Number**

EP 20 16 5274

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2016/170886 A1 (NIDEC SANKYO CORP [JP]) 27 October 2016 (2016-10-27) | 1,3-6,8 | INV. $G01P13/00$ $B65G43/08$ $G01D5/14$ |
| Y | * the whole document * | 2,3,7 | |
| X | JP H07 260943 A (SANKO ELECTRONIC LAB) 13 October 1995 (1995-10-13) | 1,4-6,8 | |
| Y | * the whole document * | 2,3,7 | |
| X | EP 2 254 076 A1 (OMRON TATEISI ELECTRONICS CO [JP]) 24 November 2010 (2010-11-24) | 1,7,8 | |
| Y | * page 5, paragraph 17 - page 19, paragraph 147; figures 1, 2, 4 * | 2,3,7 | |
| Y | DE 100 11 230 A1 (MESUTRONIC GERAETEBAU GMBH [DE]) 27 February 2003 (2003-02-27) * the whole document * | 2 | |

**TECHNICAL FIELDS SEARCHED (IPC)**

G01P
B65G
G01D

The present search report has been drawn up for all claims

| Place of search | Date of completion of the search | Examiner |
|---|---|---|
| Munich | 12 August 2020 | Springer, Oliver |

EPO FORM 1503 03.82 (P04C01)

## ANNEX TO THE EUROPEAN SEARCH REPORT
## ON EUROPEAN PATENT APPLICATION NO.

EP 20 16 5274

This annex lists the patent family members relating to the patent documents cited in the above-mentioned European search report.
The members are as contained in the European Patent Office EDP file on
The European Patent Office is in no way liable for these particulars which are merely given for the purpose of information.

12-08-2020

| Patent document cited in search report | | Publication date | Patent family member(s) | | Publication date |
|---|---|---|---|---|---|
| WO 2016170886 | A1 | 27-10-2016 | JP<br>WO | 2016206068 A<br>2016170886 A1 | 08-12-2016<br>27-10-2016 |
| JP H07260943 | A | 13-10-1995 | JP<br>JP | 3331531 B2<br>H07260943 A | 07-10-2002<br>13-10-1995 |
| EP 2254076 | A1 | 24-11-2010 | CN<br>EP<br>JP<br>JP<br>US<br>WO | 101960468 A<br>2254076 A1<br>5182564 B2<br>2009211548 A<br>2011001621 A1<br>2009110317 A1 | 26-01-2011<br>24-11-2010<br>17-04-2013<br>17-09-2009<br>06-01-2011<br>11-09-2009 |
| DE 10011230 | A1 | 27-02-2003 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H1172479 B